# EUROPEAN PATENT APPLICATION

(11) **EP 3 040 762 A1**
(43) Date of publication of application: **06.07.2016**
(21) Application number: 14839035.4
(22) Date of filing: 01.09.2014
(51) Int. Cl.: G02C 7/10, C23C 14/24, G02B 5/26, G02B 5/28, G02C 7/02

(54) **SPECTACLE LENS AND METHOD FOR PRODUCING SAME**

(30) Priority: 30.08.2013 JP 2013180223
(71) Applicant: HOYA Corporation, Tokyo 161-8525 (JP)
(72) Inventor: NISHIMOTO Keiji, Tokyo 161-8525 (JP)
(74) Representative: Hoffmann Eitle
(86) International application number: PCT/JP2014/072963
(87) International publication number: WO 2015/030245

(57) **Abstract**

An aspect of the present invention relates to a spectacle lens where at least one of an object-side surface and an eyeball-side surface has, in a lower region positioned downward from a fitting point or an optical center during use, reflection characteristics satisfying that: (1) a normal incidence average reflectance in a wavelength region of 400 to 500 nm is within a range of 1.0 to 15%; and (2) the normal incidence average reflectance is greater than a normal incidence average reflectance in the wavelength region of 400 to 500 nm in an upper region positioned upward from the lower region during use.

## Description

### Technical Field

The present invention relates to a spectacle lens and a method for producing the spectacle lens and, more particularly, to a spectacle lens capable of mitigating a burden of blue light to the eye with preferable wearing feeling and a method for producing the spectacle lens.

### Background Art

In recent years, monitor screens of digital devices have migrated from cathode-ray tubes to liquid crystals and recently to LED liquid crystals. However, liquid crystal monitors, especially LED liquid crystal monitors, intensely emit short-wavelength light of approximately 400 to 500 nm, called blue light. Therefore, in order to effectively mitigate asthenopia or ocular pain that occurs due to long time use of digital devices, it is desirable to take a countermeasure against blue light.

In this regard, Patent Literature 1 proposes an optical product including a multilayer film having characteristics of reflecting blue light.

### Citation List

### Patent Literature

Patent Literature 1: JP 2012-093689 A

### Summary of Invention

### Technical Problem

As a countermeasure against blue light, imparting characteristics of reflecting blue light (hereinafter also referred to as "blue light reflection characteristics") to a surface of a spectacle lens allows for reducing the amount of blue light entering an eye of a spectacle wearer via the spectacle lens. This can mitigate a burden of blue light to the eye.

However, it is also desired that spectacle wearer can wear the spectacle lens with preferable wearing feeling. A study by the present inventor has revealed that a spectacle lens imparted with the blue light reflection characteristics does not always have preferable wearing feeling and thus further improvement is desired.

Therefore, an object of the present invention is to provide a spectacle lens capable of mitigating a burden of blue light to the eye with preferable wearing feeling.

### Solution to Problem

As the present inventor conducts examinations in order to achieve the above object, it becomes clear that main reasons for degradation of wearing feeling of the spectacle lens having the blue light reflection characteristics include ghost.

The ghost is a phenomenon that occurs due to multiple reflection of light, incident on a spectacle lens, within the lens (double image or flicker). Imparting the blue light reflection characteristics to a surface of the spectacle lens results that multiple reflection of short-wavelength light including blue light tends to occur within the lens. This can be the major cause for ghost occurrence in the spectacle lens having the blue light reflection characteristics. Therefore, reducing the blue light reflection characteristics of the spectacle lens can suppress ghost occurrence. In this manner, however, mitigating a burden of blue light to the eye becomes difficult.

Thus, the present inventor further conducted examination on the above point. As a result, it was newly found that mitigation of a burden of blue light to the eye and preferable wearing feeling can be simultaneously achieved by selectively imparting the blue light reflection characteristics to a region positioned downward during use of a spectacle lens and reducing the blue light reflection characteristics in a region positioned upward or not imparting the blue light reflection characteristics to the region positioned upward. This is a new finding obtained when the present inventor paid attention to a fact that a region mainly used for looking at a source of blue light (personal computer, smartphone, tablet terminal, etc.) is a lower region of the spectacle lens while ghost occurs mostly in distance vision using an upper region of the spectacle lens.

The present invention has been completed based on the above finding.

That is, the above object has been achieved by the following means.
[1] A spectacle lens wherein at least one of an object-side surface and an eyeball-side surface has, in a lower region positioned downward from a fitting point or an optical center during use, reflection characteristics satisfying that:
   (1) a normal incidence average reflectance in a wavelength region of 400 to 500 nm is within a range of 1.0 to 15%; and
   (2) the normal incidence average reflectance is greater than a normal incidence average reflectance in the wavelength region of 400 to 500 nm in an upper region positioned upward from the lower region during use.
[2] The spectacle lens according to [1], wherein the surface having the reflection characteristics further has reflection characteristics where a normal incidence reflectance in the wavelength region of 400 to 500 nm successively or gradually increases from a region positioned upward to a region positioned downward during use.
[3] The spectacle lens according to [1] or [2], wherein a lens base material has a multilayer film directly or indirectly thereon and thereby the reflection characteristics are imparted thereto by the multilayer film.
[4] The spectacle lens according to any one of [1] to [3], wherein a thickness of the multilayer film varies successively or gradually from a portion positioned upward to a portion positioned downward during use.
[5] The spectacle lens according to any one of [1] to [4], wherein only one of the object-side surface and the eyeball-side surface has the reflection characteristics.
[6] The spectacle lens according to any one of [1] to [4], wherein both of the object-side surface and the eyeball-side surface have the reflection characteristics.
[7] A method for producing the spectacle lens according to any one of [3] to [6], including the step of forming the multiple deposition layer by repeating a plurality of vapor deposition steps for depositing a vapor deposition material onto a surface to be deposited of the lens base material, wherein, by disposing a shielding member over a portion of the surface to be deposited corresponding to the upper region or the lower region, an amount of deposition of the vapor deposition material thereto is reduced in at least one step of the plurality of vapor deposition steps.
[8] The method for producing the spectacle lens according to [7], wherein the vapor deposition step, performed while the shielding member is disposed, is a first step or a last step of the plurality of vapor deposition steps.

### Advantageous Effects of Invention

The present invention allows for providing a spectacle lens capable of preventing or mitigating asthenopia or ocular pain upon use of digital devices with preferable wearing feeling.

### Brief Description of Drawings

Figs. 1A to 1E are schematic diagrams of a flow illustrating an exemplary method of producing a spectacle lens surface having the reflection characteristics (1) and (2) in a lower region thereof.
Fig. 2 is a schematic plane view of a multilayer film formed by the flow an outline of which is illustrated in Fig. 1.
Fig. 3 is a schematic diagram illustrating a preferable combination of coating films disposed on both surfaces of a minus lens base material.
Fig. 4 is a schematic diagram illustrating a preferable combination of coating films disposed on both surfaces of a plus lens base material.
Fig. 5 illustrates a configuration of a vapor deposition apparatus that can be used in an aspect of the present invention.
Fig. 6 is a schematic plane view of a mechanical mask (shielding member) used in an example.
Fig. 7 illustrates film thicknesses (physical film thickness (in nm)) and normal incidence average reflectances in a wavelength region of 400 to 500 nm at seven points on a linear line passing through fitting points of respective layers included in a multilayer film formed on an object-side surface in Example 1.
Fig. 8 is a reflection spectrum (normal incidence reflection spectral characteristic) in a wavelength region of 380 to 780 nm of the spectacle lens produced in Example 1.
Fig. 9 is a transmission spectrum (normal incidence transmission spectral characteristics) in a wavelength region of 380 to 780 nm of the spectacle lens produced in Example 1.
Fig. 10 illustrates a multiple reflection spectrum for one time of light normally incident from the seven points on a convex surface of the spectacle lens produced in Example 1.
Fig. 11 illustrates standard spectral sensitivity of a human eye.
Fig. 12 is a spectrum obtained by multiplying the spectrum illustrated in Fig. 10 with spectral sensitivities in a bright place and a dark place illustrated in Fig. 11.
Fig. 13 illustrates a chromaticity coordinate of transmission light obtained from the transmission spectrum illustrated in Fig. 9 after calculation with Lab(CIE)2° and a light source of CIE-D65.
Fig. 14 illustrates a chromaticity coordinate of reflection light from a convex surface (object-side surface) obtained from the reflection spectrum illustrated in Fig. 8 after calculation with Lab (CIE) 2 ° and a light source of CIE-D65.

### Description of Embodiments

In a spectacle lens according to the present invention, at least one of an object-side surface and an eyeball-side surface has, in a lower region positioned downward from a fitting point or an optical center during use (hereinafter simply referred to as "lower region"), reflection characteristics satisfying the following (1) and (2):
(1) A normal incidence average reflectance in a wavelength region of 400 to 500 nm is within a range of 1.0 to 15%; and
(2) the normal incidence average reflectance is greater than a normal incidence average reflectance in the wavelength region of 400 to 500 nm in an upper region positioned upward from the lower region during use (hereinafter simply referred to as

### "upper region").

The spectacle lens of the present invention will be further described in detail below.

In a spectacle lens according to the present invention, at least one of the object-side surface and the eyeball-side surface has the reflection characteristics (1) and (2) in the lower region positioned downward from the fitting point or the optical center during use.

The lower region is mainly used when a spectacle wearer looks at a source of blue light. Therefore, imparting the reflection characteristics (1) to this region allows for reducing a burden of blue light to an eye. However, when the blue light reflection characteristics are imparted to the entire surface of the spectacle lens in a uniform manner, ghost occurs as described above and wearing feeling of the spectacle lens is deteriorated.

Therefore, in the present invention, the blue light reflection characteristics are reduced in the upper region positioned upward from the lower region during use than in the lower region or not imparted to the upper region. Since the major reasons for ghost occurrence include that light from the sunlight, room light, night-time illumination (street lamp), or the like, which is incident from an upper side of the spectacle lens, is subjected to multiple reflection within the lens, ghost occurs mainly in distance vision using the upper region of the spectacle lens. While paying attention to this point, the present invention selectively imparts the blue light reflection characteristics to the lower region than to the upper region (reflection characteristics (2)), thereby allowing for simultaneously achieving mitigation of a burden of blue light to the eye and preferable wearing feeling (mitigation or prevention of ghost).

Means for imparting the reflection characteristics (1) and (2) to the spectacle lens surface include a method for forming a coating film having the reflection characteristics (1) at least in the lower region of the spectacle lens surface and a method for locally disposing an additive, having characteristics of reflecting blue light, in the lower region of a surface layer of the spectacle lens. From a perspective of easily imparting the desired reflection characteristics, the method of forming the coating film is preferable. Usually, the coating film selectively reflecting light in a predetermined wavelength region is formed by laminating a plurality of optical layers. Also in the present invention, the multilayer film formed in such a manner allows for implementing the reflection characteristics (1) and (2). That is, a spectacle lens according to a preferable aspect of the present invention includes a multilayer film directly or indirectly on a lens base material and the reflection characteristics (1) and (2) are imparted thereto by the multilayer film.

Specific aspects of the multilayer film will be described below. Note that the present invention is not limited to the specific aspects below. A spectacle lens of the present invention includes any spectacle lens imparted with the reflection characteristics (1) and (2) at least on one of the object-side surface and the eyeball-side surface.

The multilayer film for imparting the blue light reflection characteristics of the reflection characteristics (1) in the lower region of the lens surface can be formed by sequentially laminating a high refractive index layer and a low refractive index layer. More specifically, the multilayer film can be formed by, first determining the thickness of respective layers through optical simulation by a known method based on a refractive index of a film material to form the high refractive index layer and low refractive index layer and a wavelength of light to be reflected, i.e. blue light, and then sequentially laminating the high refractive index layer and low refractive index layer under film formation conditions determined such that the determined thickness is achieved. Further, a material with a high refractive index to form the high refractive index layer may be an oxide selected from the group consisting of Ta₂O₅, ZrO₂, TiO₂, Al₂O₃, Y₂O₃, HfO₂, and Nb₂O₅. Meanwhile, a material with a low refractive index to form the low refractive index layer may be SiO₂ or MgF₂. Note that, an oxide and fluoride are expressed here in a stoichiometric composition for convenience; however, an oxide or fluoride where oxygen or fluorine is deficient or excessive as compared to the stoichiometric composition may also be used as a material with a high refractive index or a material with a low refractive index.

The thickness of respective layers included in the multilayer film can be determined through optical simulation as described above. A layer configuration of the multilayer film may be, for example, a configuration where a first layer (low refractive index layer), second layer (high refractive index layer), third layer (low refractive index layer), fourth layer (high refractive index layer), fifth layer (low refractive index layer), sixth layer (high refractive index layer), and seventh layer (low refractive index layer) are laminated in the order mentioned from the lens base material side to the outermost side of the lens surface, or a configuration where a first layer (high refractive index layer), second layer (low refractive index layer), third layer (high refractive index layer), fourth layer (low refractive index layer), fifth layer (high refractive index layer), and sixth layer (low refractive index layer) are laminated in the order mentioned from the lens base material side to the outermost side of the lens surface. Preferably, the aforementioned respective layers are formed by vapor deposition using a vapor deposition source including the aforementioned material with a high refractive index or material with a low refractive index as the principal component. Here, the principal component contributes to the largest part of the deposition source and usually contributes to approximately 50 to 100 wt%, or even 90 to 100 wt%. Note that the vapor deposition source may include a minute amount of impurities that inevitably enter and may include another component such as another inorganic substance or a known additive component that supports vapor deposition as long as the component does not degrade the function of the principal component. Further, the vapor deposition in the present invention includes a dry method such as a vacuum vapor deposition method, ion plating method, or sputtering method. In the vacuum vapor deposition method, an ion beam assist method for irradiating with an ion beam concurrently to vapor deposition may be used.

The multilayer film may also include one or more conductive oxide layers, formed by vapor deposition using a vapor deposition source including a conductive oxide as the principal component, in an arbitrary position in the multilayer film in addition to the high refractive index layer and low refractive index layer as described above. Preferably, indium oxide, tin oxide, zinc oxide, or titania that is known as a transparent conductive oxide or a composite oxide thereof is used as the conductive oxide such that transparency of the spectacle lens is not degraded. A conductive oxide especially preferable from the perspective of transparency and conductivity may be indium-tin oxide (ITO). By including the conductive oxide layer, adherence of dust to the charged spectacle lens can be prevented.

In the spectacle lens according to the present invention, the lower region of at least one of the object-side surface and the eyeball-side surface has the reflection characteristics (1) . In the lower region mainly used when a spectacle wearer looks at a source of blue light, allowing a normal incidence average reflectance in the wavelength region of 400 to 500 nm to be 1.0% or more enables mitigating a burden of blue light to an eye. Meanwhile, the higher the blue light reflection characteristics is, the more a burden of blue light to an eye can be mitigated; however, the higher blue light reflection characteristics change an appearance of the spectacle lens with reflection light especially from the object-side surface (occurrence of interference color). Moreover, the spectacle wearer feels uncomfortable brightness especially from the reflection light of blue light incident from the eyeball side (return light of light incident from the rear side). When the normal incidence average reflectance is 15% or less, such an influence is small and thus the normal incidence average reflectance shall be 15% or less in a spectacle lens of the present invention. Preferably, the normal incidence average reflectance is 10% or less. Note that, a normal incidence average reflectance in the wavelength region of 400 to 500 nm in the lower region being within the aforementioned range refers to that a normal incidence average reflectance in the wavelength region of 400 to 500 nm measured at one or more points in the lower region is within the aforementioned range. Preferably, normal incidence average reflectances in the wavelength region of 400 to 500 nm measured at two or more points (e.g. two to ten points) are within the aforementioned range.

As described above, at least one of the object-side surface and the eyeball-side surface of the spectacle lens according to the present invention has the blue light reflection characteristics of the reflection characteristics (1) in the lower region thereof. Further reducing the blue light reflection characteristics in the upper region or not imparting the blue light reflection characteristics in the upper region allows for the lower region in at least one of the object-side surface and the eyeball-side surface to satisfy the reflection characteristics (1) and (2). In the spectacle lens according to the present invention, on the surface having the reflection characteristics (1) and (2), it is preferable that a difference between the normal incidence average reflectance in the wavelength region of 400 to 500 nm in the lower region and the normal incidence average reflectance in the upper region [(normal incidence average reflectance in lower region) - (normal incidence average reflectance in upper region)] is 2% or more from a perspective of selectively imparting the blue light reflection characteristics in the lower region while it is preferable that the difference is 14% or less from a perspective of preventing a difference in reflection characteristics in the two regions from greatly influencing an appearance and wearing feeling of the spectacle lens. Moreover, the difference may be a difference between the average value of normal incidence average reflectances measured in the lower region and the average value of normal incidence average reflectances measured in the upper region. Alternatively, the difference may be a difference between the maximum value of normal incidence average reflectance measured in the lower region and the minimum value of normal incidence average reflectance measured in the upper region.

In order not to impart the blue light reflection characteristics in the upper region, masking such as attaching a tape on the upper region surface upon performing vapor deposition can prevent deposition of a vapor deposition material onto the region. However, the spectacle lens formed in such a manner tends to present a boundary between the upper region and lower region that is clearly recognizable by the spectacle wearer and a third party facing the spectacle wearer. This is not preferable in appearance. Therefore, the surface of the spectacle lens having the reflection characteristics (1) and (2) preferably has reflection characteristics where a normal incidence average reflectance in the wavelength region of 400 to 500 nm successively or gradually increases from the upper region to the lower region (reflectance gradient).

In order to impart the aforementioned reflectance gradient on the surface of the spectacle lens, it is preferable to dispose a shielding member over a portion, of a surface to be deposited of the spectacle lens, corresponding to the upper region or lower region during use when forming at least one deposition layer in the vapor deposition step of forming the multilayer film. This allows for an amount of accumulated deposition material in the portion where the shielding member is place over to be smaller than that in other portions, thereby allowing the thickness of the deposition layer formed in that step to vary successively or gradually from the portion positioned upward to the portion positioned downward during use. An aspect of such a vapor deposition step will be described based on the drawings.

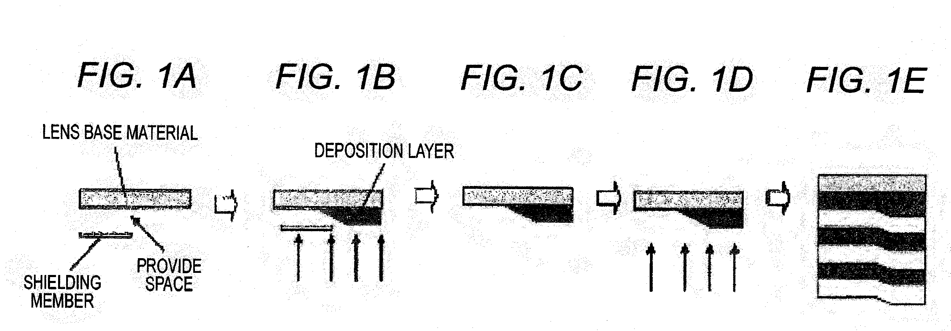

Figs. 1A to 1E are schematic diagrams of a flow illustrating an exemplary method of producing a spectacle lens surface having the reflection characteristics (1) and (2) in a lower region thereof. In Figs. 1A to 1E, the spectacle lens base material is illustrated as a flat surface lens; however, the spectacle lens base material of the present invention is not limited to the ones both surfaces of which are flat. This point will be described later. Further, Figs. 1A to 1E illustrate an aspect where a vapor deposition source is disposed under the spectacle lens base material and a vapor deposition material is evaporated toward a surface of the spectacle lens base material; however, the arrangement of the spectacle lens base material and the vapor deposition material can be vice versa.

First, the lens base material is disposed in a vapor deposition apparatus with a surface to be deposited of the lens base material facing toward the vapor deposition source side. The vapor deposition apparatus may be a known vapor deposition apparatus. An exemplary vapor deposition apparatus that can be used in the present invention will be described in another example to be described later.

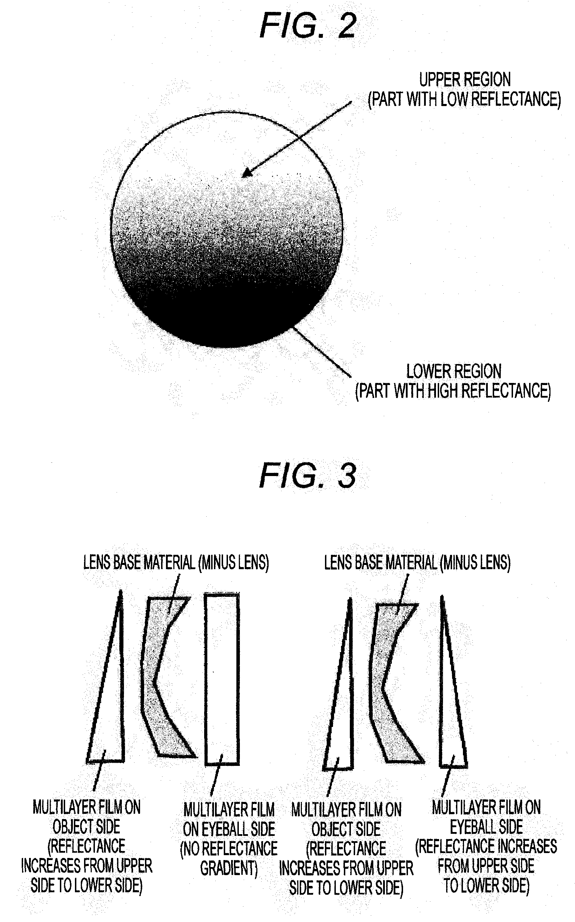

When forming a deposition layer with varying thickness within a surface thereof in the vapor deposition apparatus, a shielding member is disposed over a portion, between the surface to be deposited of the lens base material and the vapor deposition source, corresponding to the upper region or lower region (Fig. 1A). Here, the shielding member is disposed without being in contact with the surface to be deposited of the lens base material but with a space therebetween. When the vapor deposition material evaporates from below in this state, a large amount of vapor deposition material deposits in a portion where there is no shielding member thereover on the surface to be deposited of the lens base material while, in a portion where there is the shielding member thereover, a small amount of vapor deposition material deposits near a boundary with the portion where there is no shielding member thereover. The amount of deposition decreases as it departs from the boundary (Fig. 1B). In this manner, the deposition layer can be formed where the thickness thereof varies successively or gradually from the portion positioned upward to the portion positioned downward during use. Thereafter, the shielding member is removed (Fig. 1C) and the vapor deposition step is repeated. This allows for forming the multilayer film on the surface to be deposited of the lens base material (Figs. 1D and 1E). A schematic plane view of a multilayer film formed in this manner is illustrated in Fig. 2. Note that the deposition layer having different thicknesses within a surface thereof can be formed, in the multilayer film, at least one in number and may be formed two or more in number. For example, in one aspect, the thinner the low refractive index layer is, the lower blue light reflection characteristics become and the thicker the high refractive index layer is, the higher the blue light reflection characteristics becomes. In this case, forming the low refractive index layer to be thicker in the lower region than in the upper region or forming the high refractive index layer to be thinner in the lower region than in the upper region can result in the higher blue light reflection characteristics in the lower region than in the upper region. Inversely, in an aspect where a thinner low refractive index layer results in the higher blue light reflection characteristics while a thicker high refractive index layer results in a lower blue light reflection characteristics, forming the layers in an inverse manner can result in the higher blue light reflection characteristics in the lower region than in the upper region.

Note that disposing and removing the shielding member in an intermediate step in the plurality of vapor deposition steps for forming the multilayer film complicates the producing step. Therefore, from a perspective of simplifying the steps, it is preferable that the vapor deposition step performed with the shielding member disposed is included in the plurality of vapor deposition steps as the first step or as the last step, that is, performed as a step of forming the first layer or the uppermost layer in the multilayer film.

As described above, the present invention also provides a method for producing the spectacle lens according to the present invention where a lens base material has a multilayer film directly or indirectly thereon and the reflection characteristics are imparted to the spectacle lens by the multilayer film.

The method for producing the spectacle lens includes the step of forming the multiple deposition layer by repeating a plurality of vapor deposition steps for depositing a vapor deposition material onto a surface to be deposited of the lens base material, where, by disposing a shielding member over a portion of the surface to be deposited corresponding to the upper region or the lower region, an amount of deposition of the vapor deposition material thereto is reduced in at least one step of the plurality of vapor deposition steps. This allows for providing the spectacle lens where the lower region in at least one of the object-side surface and the eyeball-side surface has the reflection characteristics (1) and (2).

In the spectacle lens according to the present invention, the surface having the reflection characteristics (1) and (2) in the lower region thereof may be any one of the object-side surface and the eyeball-side surface or the both. When the lens base material is a minus lens where a thickness in a center part is thinner than that in a peripheral part, it is preferable that at least an object-side surface has the reflection characteristics (1) and (2) in the lower region thereof. When the lens base material is a plus lens where a thickness in a center part is thicker than that in a peripheral part, it is preferable that at least an eyeball-side surface has the reflection characteristics (1) and (2) in the lower region thereof. This is because, in a minus lens, light incident on the eyeball-side surface from the upper rear side of the spectacle wearer is reflected by the object-side surface and the amount of light entering the eye of the spectacle wearer as return light tends to be large due to the shape of the lens. Therefore, it is desired that the blue light reflection characteristics in the upper region of the object-side surface is low, thereby preventing occurrence of return light. On the other hand, in a plus lens, light incident on the eyeball-side surface from the upper rear side of the spectacle wearer is reflected by the same surface and thereby the amount of light entering the eye of the spectacle wearer tends to be large due to the shape of the lens. Therefore, it is desired that the blue light reflection characteristics in the upper region of the eyeball-side surface is low, thereby preventing occurrence of reflection light in the upper region on the eyeball-side surface.

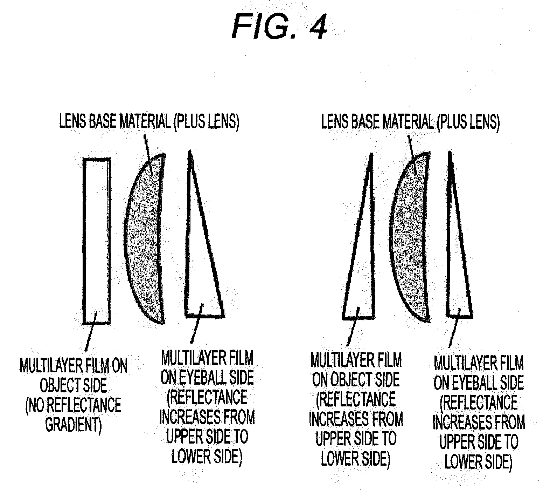

In either case, the other surface may be and may not be imparted with the blue light reflection characteristics. When imparting the blue light reflection characteristics on the other surface, the other surface may also have the reflection characteristics (1) and (2) in the lower region thereof in a similar manner or may have no difference in the normal incidence average reflectances in the wavelength region of 400 to 500 nm between the upper region and the lower region (no reflectance gradient). The above aspects are schematically illustrated in Fig. 3 (minus lens) and Fig. 4 (plus lens). Note that even if the film is formed under uniform conditions over the entire surface of the lens, a difference in reflectance of ±1% is generated within a surface due to influence of surface shape of the lens or the like. Therefore, the aforementioned surface without a reflectance gradient includes a surface having a difference in reflectance of ±1% within the surface. It is preferable that the normal incidence average reflectance in the wavelength region of 400 to 500 nm (blue light reflection characteristics) on the surface without a reflectance gradient is lower than the blue light reflection characteristics in the lower region of the other surface. This is to obtain an effect of lowering (or not imparting) the blue light reflection characteristics in the upper region of the other surface more effectively. On the other hand, dispersely imparting the blue light reflection characteristics on both of the lens surfaces is effective for preventing blue light incident on the lens from various directions from entering the eye. Therefore, it is preferable to impart the blue light reflection characteristics even to the surface without a reflectance gradient. From a perspective of suppressing ghost, it is preferable that the blue light reflection characteristics (normal incidence average reflectance in the wavelength region of 400 to 500 nm) on the surface without a reflectance gradient is equal to or lower than that in the upper region of the other surface. Such blue light reflection characteristics can be imparted to one surface of the lens preferably by forming the coating film on the lens base material or more preferably by forming the multilayer film. As for a method for forming the multilayer film formed here, the descriptions above can be referred to. By forming the multilayer film without imparting varying thicknesses, the surface having the blue reflection characteristics without a reflectance gradient can be formed.

The multilayer film as described above may be directly formed on the lens base material surface or be formed indirectly on the lens base material via one or more layers of functional films. The lens base material is not specifically limited but may be (meth) acrylic resin, styrene resin, polycarbonate resin, allyl resin, allyl carbonate resin such as diethyleneglycol bis(allylcarbonate)resin (CR-39), vinyl resin, polyester resin, polyether resin, urethane resin obtained through reaction between an isocyanate compound and a hydroxy compound such as diethylene glycol, thiourethane resin obtained through reaction between an isocyanate compound and a polythiol compound, transparent resin obtained by curing a polymerizable composition containing a (thio)epoxy compound having one or more intermolecular disulfide bonds, and the like. Alternatively, inorganic glass may also be used. A refractive index of the lens base material may be, for example, approximately 1.60 to 1.75. Note that the refractive index of the lens base material is not limited thereto but may be within the aforementioned range or depart therefrom.

The spectacle lens of the present invention may be various lenses including a monofocal lens, multifocal lens, and progressive refraction lens. A type of the lens is determined by shapes of both surfaces of the lens base material. For example, in a progressive refraction lens, a near vision region (near vision part) and a progressive region (intermediate region) are included in the aforementioned lower region and a distance vision region (distance vision part) is included in the upper region. Further, the lens base material surface may be a convex, concave, or flat surface. In a general lens base material, an object-side surface is a convex surface and an eyeball-side surface is a concave surface. Note that the lens base material used in the present invention is not limited thereto.

The functional film that may be formed between the lens base material and multilayer film may be a hard coat layer. Providing a hard coat layer allows for imparting flaw resistance (abrasion resistance) to the spectacle lens and improving durability (strength) of the spectacle lens. As for details of the hard coat layer, for example, paragraphs 0025 to 0028 and 0030 of JP 2012-128135 A may be referred to. Further, as the functional film, a primer layer for enhancing adhesion may be formed. As for details of the primer layer, for example, paragraphs 0029 to 0030 of JP 2012-128135 A may be referred to.

A functional film can be further formed on the multilayer film. Such a functional film may be a water repellent or hydrophilic antifouling layer. As for details thereof, paragraphs 0040 to 0042 of JP 2012-128135 A may be referred to.

The spectacle lens of the present invention as described above allows for effectively suppressing blue light that is a burden to the eye to enter the eye in addition to providing preferable wearing feeling since ghost occurrence in the distance vision is mitigated.

### Examples

The present invention will be further described with examples below; however, the present invention is not limited to aspects illustrated in the examples.

### [Example 1]

### 1-1. Selection of lens base material and formation of hard coat layer

As a lens base material, a minus lens (progressive refraction lens) of a plastic lens base material for spectacles with a refractive index of 1.67 (product name: SSV/ a product by HOYA Corporation) was used.

A coating liquid for forming a hard coat layer was prepared as follows. An epoxy resin-silica hybrid (product name: COMPOCERAN E102, a product by ARAKAWA Chemical Industries, LTD. ) of 20 parts by mass was mixed with an acid anhydride-based curing agent (product name: Curing Agent C2, a product by ARAKAWA Chemical Industries, LTD.) of 4.46 parts by mass and stirred to obtain the coating liquid. This coating liquid was applied to each of the object-side surface and eyeball-side surface of the lens base material using a spin coater such that a predetermined thickness is achieved. The lens base material after application was subjected to baking at 125°C for two hours to form a hard coat layer with a thickness of 1000 to 3000 nm where silica and titania sol are fixed with resin.

The lens base material where the hard coat layer is formed on both of the surfaces as above is hereinafter referred to also as a lens sample.

### 1-2. Formation of multilayer film on object-side surface and eyeball-side surface

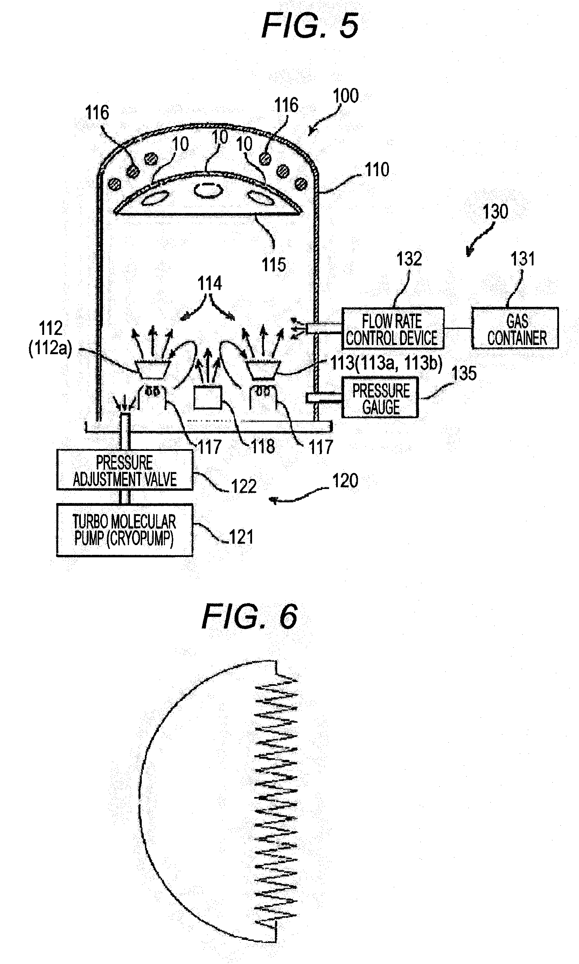

Using a vapor deposition apparatus illustrated in Fig. 5, a multilayer film was formed on each of the object-side surface and eyeball-side surface. In the present example, the multilayer film was formed on the object-side surface (convex surface) such that the lower region thereof has the reflection characteristics (1) and (2) and the multilayer film without a reflectance gradient was formed on the eyeball-side surface (concave surface).

A configuration of a vapor deposition apparatus illustrated in Fig. 5 will be described below.

A vapor deposition apparatus 100 illustrated in Fig. 5 is capable of successively forming (producing) a plurality of deposition layers. The vapor deposition apparatus 100 is an electron beam vapor deposition apparatus and includes a vacuum chamber 110, an exhaust device 120, and a gas supply device 130. The vacuum chamber 110 includes a sample support 115, on which a lens sample 10 formed with a hard coat layer is mounted, a base material heating heater 116 for heating the lens sample 10 mounted on the sample support 115, and a filament 117 for generating thermions. The base material heating heater 116 may be, for example, an infrared lamp. The base material heating heater 116 heats up the lens sample 10 for releasing gas or evaporating water to ensure adhesion of layers formed on a surface of the lens sample 10.

The vapor deposition apparatus 100 further includes an accommodation part 112 for accommodating a vapor deposition source 112a for forming the low refractive index layer and an accommodation part 113 for accommodating a vapor deposition source 113a for forming the high refractive index layer. Specifically, the accommodation part 112 is provided with a crucible (not shown) for accommodating the vapor deposition source 112a and the accommodation part 113 is provided with another crucible (not shown) for receiving the vapor deposition source 113a.

Any of the vapor deposition sources (metal oxide) accommodated in the crucible is irradiated with thermions 114 by an electron gun (not shown) to cause evaporation, thereby successively forming respective layers on the lens sample 10. In the present example, granules of SiO₂ were used as the vapor deposition source 112a while a sintered compact of ZrO₂ (tablet) was used as the vapor deposition source 113a.

The vapor deposition apparatus 100 further includes an ion gun 118 for ionizing and accelerating gas introduced to an inner part of the vacuum chamber 110 and irradiating the lens sample 10 therewith in order to enable ion assisted deposition. The vacuum chamber 110 may further include a cold trap for removing residual water, a device for managing the layer thickness, or the like. The device for managing the layer thickness may be, for example, an optical thickness meter of a reflection type or a crystal oscillator thickness meter.

The inner part of the vacuum chamber 110 can be maintained in a high vacuum state, for example at 1 × 10⁻⁴ Pa, by a turbo molecular pump or a cryopump 121 and a pressure adjustment valve 122 included in the exhaust device 120. Meanwhile, the inner part of the vacuum chamber 110 can also be caused to be in predetermined gas atmosphere by the gas supply device 130. For example, a gas container 131 included in the gas supply device 130 contains argon (Ar), nitrogen (N₂), oxygen (O₂), etc. The flow rate of gas can be controlled by a flow rate control device 132. The internal pressure of the vacuum chamber 110 can be controlled by a pressure gauge 135.

Major vapor deposition conditions in the vapor deposition apparatus 100 includes a vapor deposition material, acceleration voltage and a current value of the electron gun, and whether ion assist is performed. Conditions where an ion assist is used are given by a type of ion (atmosphere in the vacuum chamber 110), an acceleration voltage value and an ion current value of the ion gun 118. Hereinafter, the acceleration voltage and current value of the electron gun are within a range of 5 to 10 kV and a range of 50 to 500 mA, respectively, based on a film forming rate or the like unless otherwise specified. Further, when the ion assist is used, the voltage value and current value of the ion gun 118 are within a range of 200 V to 1 kV and a range of 100 to 500 mA, respectively, based on a film forming rate or the like.

Next, pretreatment to apply to a surface (surface of the hard coat layer) to be deposited before performing vapor deposition will be described.

The lens sample 10 formed with the hard coat layer was washed with acetone. The lens sample 10 was then subjected to heating processing at approximately 70°C in the vacuum chamber 110 to evaporate water attached thereto. Next, a surface of the lens sample 10 was subjected to ion cleaning. Specifically, the surface of the lens sample 10 was irradiated with an oxygen ion beam at an energy of several hundreds electron volts using the ion gun 118 and an organic matter attached to the surface of the lens sample 10 was removed. This processing (method) allows for improving adhesion of a layer (film) to be formed on the surface of the lens sample 10. Note that a similar processing may be performed using inert gas such as argon (Ar) gas or xenon (Xe) gas or nitrogen (N₂) instead of oxygen ion. Alternatively, the surface of the lens sample 10 may be irradiated with an oxygen radical or oxygen plasma.

Next, a method of forming a multilayer film on an object-side surface where the aforementioned pretreatment has been applied to.

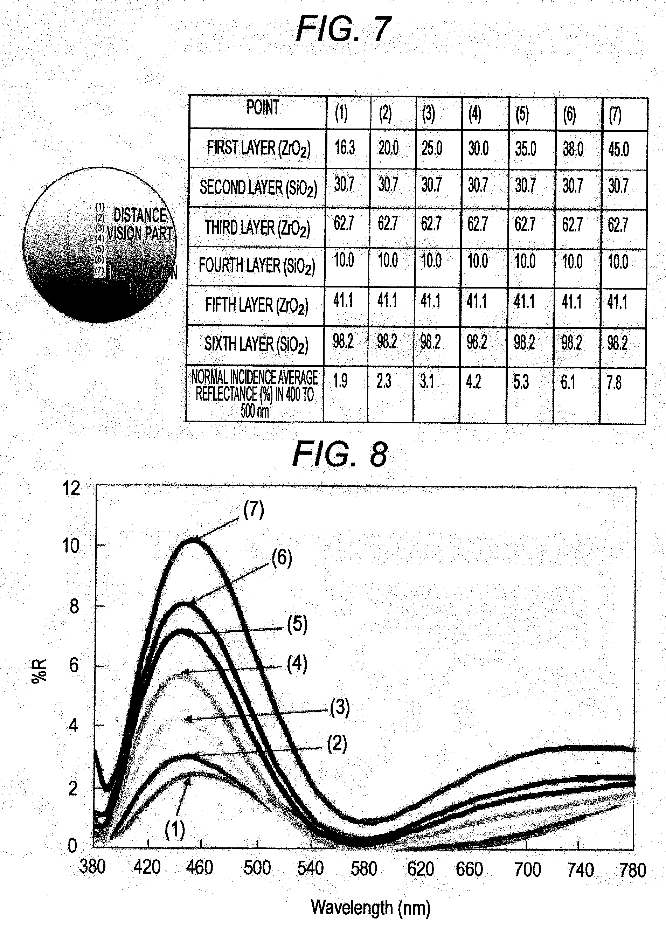

A configuration (design value) of the multilayer film formed here is illustrated in Fig. 7. The object-side surface (convex surface) includes a configuration of (1) to (7) while the eyeball-side surface (concave surface) includes a configuration of (1). The points (1) to (3), (4), and (5) to (7) each correspond to points positioned in the upper region during use, a fitting point during use, and points positioned in the lower region during use, respectively. As illustrated in Fig. 7, a first layer of high refractive index layer has a thickness gradually increasing from the portion positioned upward to the portion positioned downward during use.

The inner part of the vacuum chamber 110 was sufficiently evacuated. Thereafter, a vapor deposition step was repeated where the high refractive index layer and low refractive index layer were alternately laminated on the object-side surface of the lens sample 10 by an electron beam vacuum vapor deposition method, thereby forming a multilayer film including six layers in total. An SiO₂ layer of the low refractive index layer was formed without performing ion assist. Specifically, heating conditions with the electron beam were a voltage of 6 kV and a current of 100 mA. Here, argon gas was introduced inside the vacuum chamber 110 at 5 sccm. Meanwhile, a ZrO₂ layer of the high refractive index layer was formed by performing ion assist (ion assisted deposition). Specifically, heating conditions with the electron beam were a voltage of 6 kV and a current of 280 mA. Here, mixed gas of argon gas and oxygen gas was used for ion assist and a mixed beam of argon and oxygen was emitted at an ion acceleration voltage of 600 V and an ion beam current of 150 mA. No gas was introduced into the vacuum chamber 110.

Moreover, the vapor deposition step of the first layer of high refractive index layer (ZrO₂ layer) was performed while a mechanical mask (shielding member) was disposed over a distance vision region positioned upward from the fitting point during use as illustrated in Fig. 2A. The shielding member was disposed over the lens with a space therebetween using a holder not shown. By disposing the shielding member over the lens with a space therebetween, a boundary between the upper region and lower region becomes unclear. This also enables forming the deposition layer with a successively varying thickness. A schematic plane view of a mechanical mask used here is illustrated in Fig. 6. Since a shape of a portion, opposite to the boundary between the upper region and lower region in the surface to be deposited, is not linear but comb-shaped, the boundary between the upper region and lower region in the deposition layer is unclear as compared to a case where the shape is linear. This is preferable for obtaining a spectacle lens with a preferable appearance. A similar effect can also be gained by a shielding member having a shape including curves such as a waveform in the portion opposite to the boundary between the upper region and lower region in the surface to be deposited.

As the first layer, ZrO₂ was deposited by a thickness given by a difference between (7) and (1) in Fig. 7, namely, 45.0 nm - 16.3 nm = 28.7 nm.

Thereafter, the vapor deposition apparatus was once released to remove the mechanical mask therefrom. Evacuation was then again performed and vapor deposition was restarted. The remaining thickness of 16.3 nm for the first layer was deposited and a second and subsequent layers were deposited thereon.

Thicknesses at seven points on a linear line passing through fitting points in the respective layers of the multilayer film having been form in such a manner correspond to values of (1) to (7) illustrated in Fig. 7.

Next, the lens sample formed with the multilayer film on the object-side surface was turned upside down and mounted to the vapor deposition apparatus. A multilayer film was then formed on the eyeball-side surface (concave surface) in a similar manner as above. In this step, the mechanical mask was not used but a film with a uniform thickness was deposited on the entire surface. Specifically, vapor deposition was performed successively from a first layer to a sixth layer with a configuration of (1) in Fig. 7.

As a result of the above steps, the spectacle lens including, on both of the lens surfaces, multilayer films having the blue light reflection characteristics was obtained. In this spectacle lens, the multilayer film on the object-side surface has varying thicknesses in the first layer as illustrated in Fig. 7.

### 1-3. Measurement of reflection characteristics and transmission characteristics

Normal incidence reflection spectral characteristics were measured in a wavelength region of 380 to 780 nm using Olympus Micro Spectrophotometer USPM in the aforementioned seven points on the object-side surface (convex surface side) of the produced spectacle lens. Normal incidence average reflectances in a wavelength region of 400 to 500 nm in the aforementioned seven points are illustrated in Fig. 7 while an obtained reflection spectrum is illustrated in Fig. 8. A normal incidence average reflectance in the wavelength region of 400 to 500 nm at the fitting point on the eyeball-side surface was 1.9%, which is same as that in the point (1) in Fig. 7.

Note that the reflection spectrum illustrated in Fig. 8 was obtained by measuring a normal incidence reflectance for every 10 nm within the wavelength of 380 to 780 nm (a wavelength interval of 10 nm). However, the wavelength interval for measurement can be set arbitrary upon measuring reflection characteristics and transmission characteristics and may be set at, for example, 1 nm. As illustrated in Fig. 8, a normal incidence reflectance in the wavelength region of 400 to 500 nm can be confirmed to gradually increase from the region positioned upward to the region positioned downward during use.

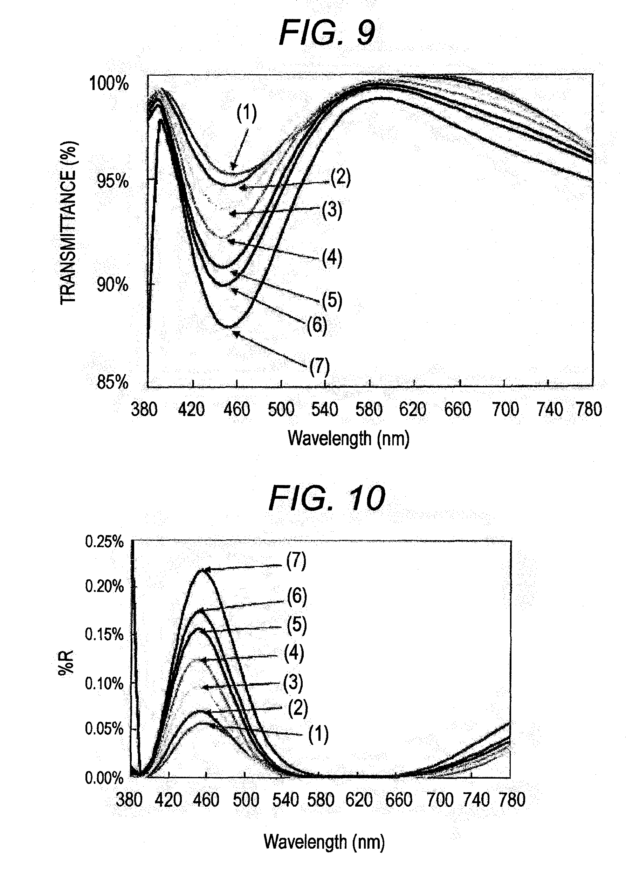

Normal incidence transmission spectral characteristics (ratio of an amount of light transmitted by the eyeball-side surface to an amount of light incident on the object-side surface) were measured in the wavelength region of 380 to 780 nm using Hitachi Spectrophotometer U-4100 in the aforementioned seven points in the produced spectacle lens (wavelength interval of 10 nm). An obtained transmission spectrum is illustrated in Fig. 9. From the result illustrated in Fig. 9, the amount of blue light, which enters the eye of the spectacle wearer after entering from the object-side surface and being transmitted by the eyeball side, can be confirmed to have reduced in the lower region of the spectacle lens as compared to the upper region. As described above, the lower region is mainly used when a spectacle wearer looks at a source of blue light. Thus, if the amount of blue light incident on an eye of a spectacle wearer in this region can be reduced, a burden caused by blue light to the eye can be effectively mitigated.

### 1-4. Confirmation of ghost mitigating effect

With light normally incident from the convex surface (object-side surface) and reflected by the concave surface (eyeball-side surface) (one-time multiple reflection), where a reflectance on the convex surface side is denoted as R1 while a reflectance on the concave surface is denoted as R2, an occurrence ratio G1 of one-time multiple reflection that occurs respectively in the convex surface and concave surface by reflection for one time is expressed by G1 = (1 - R1) × R2 × R1 × (1 - R2). From measurement results of reflection characteristics in the respective points within the surface as obtained in the above manner, a one-time multiple reflection spectrum of light normally incident from the seven points on the convex surface of the produced spectacle lens was obtained from calculations, the result of which is illustrated in Fig. 10. From the result illustrated in Fig. 10, reducing the blue light reflection characteristics in the upper region can be confirmed to be capable of suppressing occurrence of multiple reflection in the upper region. As described above, since ghost occurs mainly in distance vision using the upper region of the spectacle lens, being capable of reducing the occurrence ratio of multiple reflection in the upper region as such is effective for preventing deterioration of wearing feeling of the spectacle lens due to ghost occurrence.

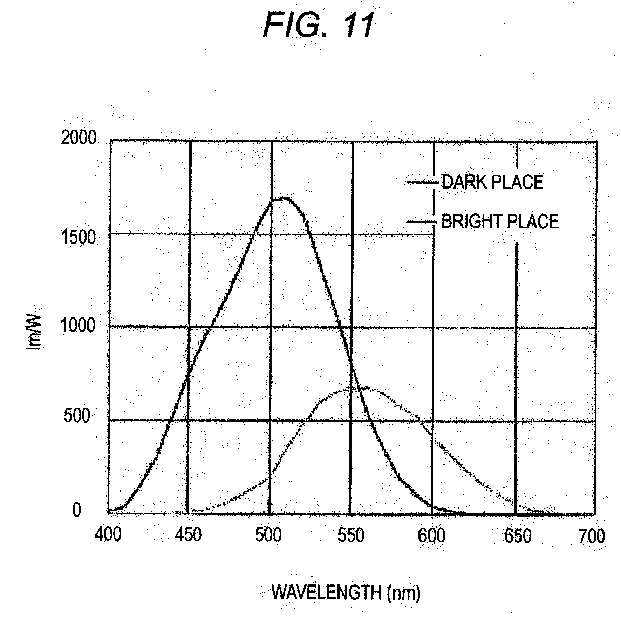

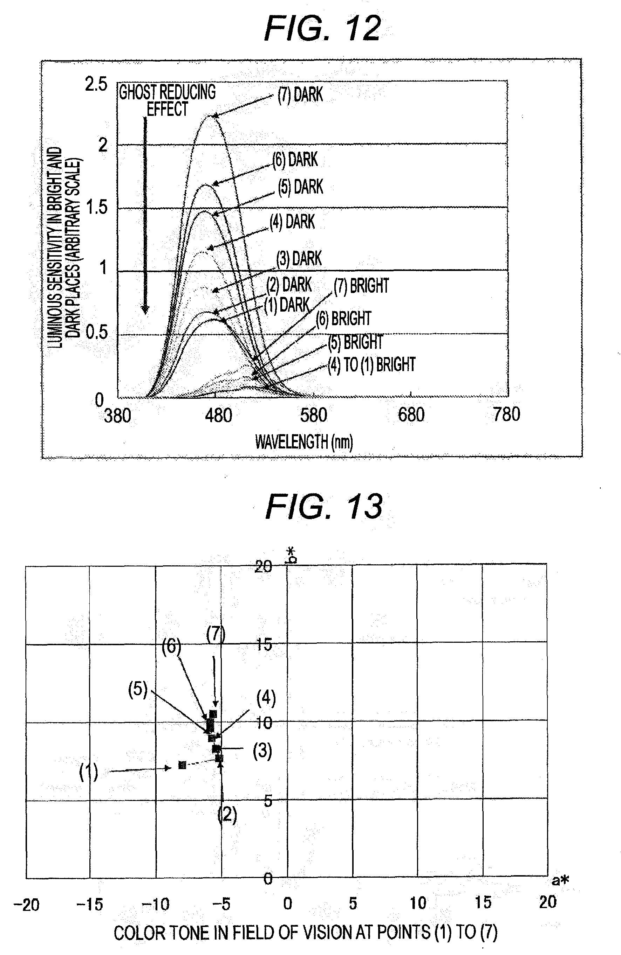

Moreover, the spectacle wearer especially tends to feel unpreferable wearing feeling due to ghost occurrence when looking at a distant illumination (fluorescent light, street light, etc.) in a dark place. Further describing this point, Fig. 11 illustrates standard spectral sensitivities (data from a public-known literature) of a human eye. Furthermore, spectrums obtained by multiplying the respective spectrums illustrated in Fig. 10 with spectral sensitivities in a bright place and a dark place illustrated in Fig. 11 are illustrated in Fig. 12.

As illustrated in Fig. 11, the human eye is more sensitive to short-wavelength light near 400 to 500 nm in a dark place as compared to a case of a bright place. Therefore, as illustrated in Fig. 12, especially in the dark place as compared to the bright place, a high effect of mitigating ghost in the upper region mainly used for looking at a distant illumination is effective for preventing deterioration of wearing feeling due to ghost occurrence in a dark place.

### 1-5. Confirmation of color tone

A chromaticity coordinate of transmission light obtained from the transmission spectrum illustrated in Fig. 9 after calculation with Lab(CIE)2° and a light source of CIE-D65 is illustrated in Fig. 13.

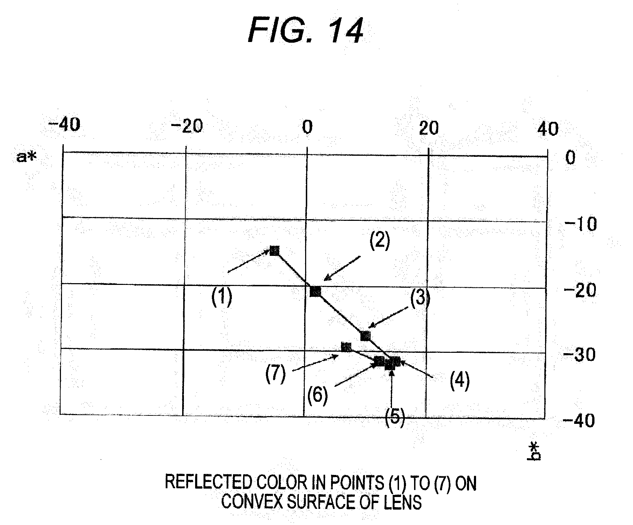

A chromaticity coordinate of reflection light from a convex surface (object-side surface) obtained from the reflection spectrum illustrated in Fig. 8 after calculation with Lab(CIE)2° and a light source of CIE-D65 is illustrated in Fig. 14.

Plots in Figs. 13 and 14 are color coordinates (normal incidence) at the aforementioned seven points of the produced spectacle lens. In the chromaticity coordinate, a larger value of b* means that yellow is stronger. The spectacle lens including the coating film having the blue light reflection characteristics tends to provide yellowish vision due to yellowish transmission light. Contrary to this, from Figs. 13 and 14, the produced spectacle lens can be confirmed to be less yellowish in the upper region. The fact that the region used for distance vision (upper region) is less yellowish allows the spectacle wearer to feel natural colors without uncomfortableness.

### [Example 2]

A spectacle lens including multiple deposition layers on both surfaces was produced in a similar manner to Example 1 except for that, as a lens base material, a minus lens (progressive refraction lens) of a plastic lens base material for spectacles with a refractive index of 1.67 (product name: SSV/ a product by HOYA Corporation), which contains a UV absorbent, was used.

### [Example 3]

A spectacle lens including multiple deposition layers on both surfaces was obtained in a similar manner to Example 1 except for that, as a lens base material, a plus lens (progressive refraction lens) of a plastic lens base material for spectacles with a refractive index of 1.67 (product name: SSV/ a product by HOYA Corporation), which contains a UV absorbent, was used and that the multiple deposition layer with a reflectance gradient was provided on the eyeball side while the multiple deposition layer without a reflectance gradient was provided.

Reflection characteristics and transmission characteristics of the spectacle lenses produced in Examples 2 and 3 were evaluated with a similar method to Example 1. As result, the spectacle lenses produced in Examples 2 and 3 were confirmed to have the reflection characteristics (1) and (2) on the lens surface including the multiple deposition layer with a reflectance gradient.

Moreover, the spectacle lenses produced in Examples 2 and 3 have low transmittance of ultraviolet rays due to the UV absorbent contained in the lens base material. Thus, the spectacle lenses were confirmed to be capable of mitigating a burden, of light in a region of ultraviolet rays, to the eye. In this manner, combining formation of the coating film having the blue light reflection characteristics and usage of an appropriate additive in the lens base material can effectively mitigate a burden of light in various wavelength regions to the eye.

The one-time multiple reflection spectrum was obtained also with the spectacle lenses produced in Examples 2 and 3 in a similar manner to Example 1 and, occurrence of multiple reflection in the upper region was confirmed to have been suppressed in a similar manner to Example 1.

### Industrial Applicability

The present invention is useful in the field of producing spectacle lenses.

## Claims

1. A spectacle lens,
wherein at least one of an object-side surface and an eyeball-side surface has, in a lower region positioned downward from a fitting point or an optical center during use, reflection characteristics satisfying that:
(1) a normal incidence average reflectance in a wavelength region of 400 to 500 nm is within a range of 1.0 to 15%; and
(2) the normal incidence average reflectance is greater than a normal incidence average reflectance in the wavelength region of 400 to 500 nm in an upper region positioned upward from the lower region during use.

2. The spectacle lens according to claim 1,
wherein the surface having the reflection characteristics further has reflection characteristics where a normal incidence reflectance in the wavelength region of 400 to 500 nm successively or gradually increases from a region positioned upward to a region positioned downward during use.

3. The spectacle lens according to claim 1 or 2,
wherein a lens base material has a multilayer film directly or indirectly thereon, and
the reflection characteristics are imparted to the spectacle lens by the multilayer film.

4. The spectacle lens according to any of claims 1 to 3,
wherein a thickness of the multilayer film varies successively or gradually from a portion positioned upward to a portion positioned downward during use.

5. The spectacle lens according to any of claims 1 to 4,
wherein only one of the object-side surface and the eyeball-side surface has the reflection characteristics.

6. The spectacle lens according to any of claims 1 to 4,
wherein both of the object-side surface and the eyeball-side surface have the reflection characteristics.

7. A method for producing a spectacle lens, wherein
the spectacle lens is the spectacle lens according to any of claims 3 to 6, and
the method comprises the step of forming the multiple deposition layer by repeating a plurality of vapor deposition steps for depositing a vapor deposition material onto a surface to be deposited of the lens base material,
wherein, by disposing a shielding member over a portion of the surface to be deposited corresponding to the upper region or the lower region, an amount of deposition of the vapor deposition material thereto is reduced in at least one step of the plurality of vapor deposition steps.

8. The method for producing the spectacle lens according to claim 7,
wherein the vapor deposition step, performed while the shielding member is disposed, is a first step or a last step of the plurality of vapor deposition steps.
